# EUROPEAN PATENT APPLICATION

(11) **EP 2 355 145 A1**
(43) Date of publication of application: **10.08.2011**
(21) Application number: 10153202.6
(22) Date of filing: 10.02.2010
(51) Int. Cl.: H01L 21/98, H01L 21/60, H05K 13/02

(54) **Pressure assisted self targeting assembly**

(71) Applicant: Nederlandse Organisatie voor Toegepast -Natuurwetenschappelijk Onderzoek TNO, 2628 VK Delft (NL)
(72) Inventor: Dietzel, Andrea Heinrich, D-47906 Kempen (DE); Van den Brand, Jeroen, 5053 AT Goirle (NL)
(74) Representative: Hatzmann, Martin

(57) **Abstract**

The invention relates to a component (10) placement method for placement of a component (10) on a flexible substrate (20), comprising: providing a flexible substrate (20); administering a component (10) to a support face, the support face comprised of by the flexible substrate or by a support structure to be aligned with the flexible substrate; generating an air flow in an out of plane orientation relative to the support face; and directing the component (10) to a placement position (30) by means of a directional structure provided on the support face; wherein the component (10) is levitated from the support face (20, 70) by said air flow or by vibrational contact between the support face and the component induced by said air flow; and wherein, when the support face is comprised by a support structure distinct from the flexible substrate, the support face is aligned with the flexible substrate. Accordingly, air cushion or intermittent contact forces (modulated in time and space using modulated micro-features) can be used to provide local interactions with the micro-part so as to position micro-parts with reference to micro-features arranged on the flexible substrate.

## Description

### FIELD OF INVENTION

The invention relates to a component placement method for placement of a component on a flexible substrate.

### BACKGROUND

Self-assembly of discrete components (chips) on a substrate is a process for which precision positioning with sufficient accuracy is necessary to allow for electrical, optical or other type of interconnects when a component becomes attached to a placement position. One example is WO 2004/051701 wherein components are guided on a carrier web towards a placement position via a gas flow. The substrates are designed with corresponding cavities, wherein the components can be held by a pressure difference provided by vacuum suction through via through holes in the cavities.

### SUMMARY OF THE INVENTION

The prior art assembly method requires a complicated interplay between pressure zones to allow directing the component over longer distances to the target position, for which the invention seeks a solution. To this end, it is proposed to provide a component placement method for placement of a component on a flexible substrate , comprising: providing a flexible substrate ; administering a component to a support face, the support face comprised of by the flexible substrate or by a support structure to be aligned with the flexible substrate; generating an air flow in an out of plane orientation relative to the support face; and directing the component to a placement position by means of a directional structure provided on the support face; wherein the component is levitated from the support face by said air flow or by vibrational contact between the support face and the component induced by said air flow; and wherein, when the support face is comprised by a support structure distinct from the flexible substrate the support face is aligned with the flexible substrate.

Accordingly, air cushion forces (modulated in time and space) can be used to provide local gas flow so as to position micro-parts of these components with reference to micro-features arranged on the flexible substrate.

### BRIEF DESCRIPTION OF THE FIGURES

Figure 1 shows a first embodiment, wherein vibrations are induced in the substrate to position a micro component; and
Figure 2 shows a second embodiment, wherein the substrate is adapted with micro-features to direct a gas flow;
Figure 3 shows a further implementation of the placement device in a reel to reel system; and
Figure 4 shows an alternative placement system.

### DETAILED DESCRIPTION

Several methods exist to assemble discrete components on substrates. For high speed assembly processes self-assembly is attractive. In an aspect, a low cost method is provided for high speed positioning of discrete components on substrates, which can be operated in a reel to reel manufacturing fashion In particular, the method can be used for very thin components, of about less than 100 micron.

The present invention concerns a method for self-assembly of discrete components (chips) on a flexible substrate on which precision positioning with sufficient accuracy is necessary to allow for electrical/optical/ or other interconnects. In an embodiment, the self assembly uses local features in the substrate through which forces are applied to the component through air flow or acoustic excitation, in particular in a low frequency range (below 1000 Hz).

In particular, the frequency can be tuned to a resonance characteristic of certain foil structures in combination with the components to be placed, to generate an effective vibration.

For instance, through openings or air vias may be provided in the flexible substrate. It is noted that throughout the text, the term flexible substrate is used, where alternatively, the term foil, or carrier web may be used as a term commonly known by the skilled person. In addition, it maybe advantageous to employ a combination of through-substrate opening and other structures e.g. to guide the air flow, or to give the air flow a direction. For instance, a non-uniform air supply, achieved by varying nozzle diameters or the nozzle density distribution may direct the component 10 to a placement position 30.

In this way, in the substrate a structure is provided allowing passage of air through the substrate (especially thin substrates with small air vias).

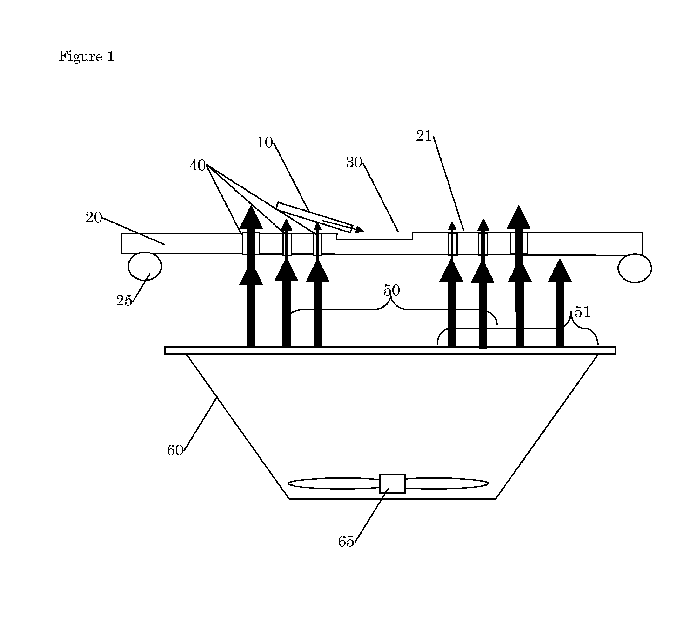

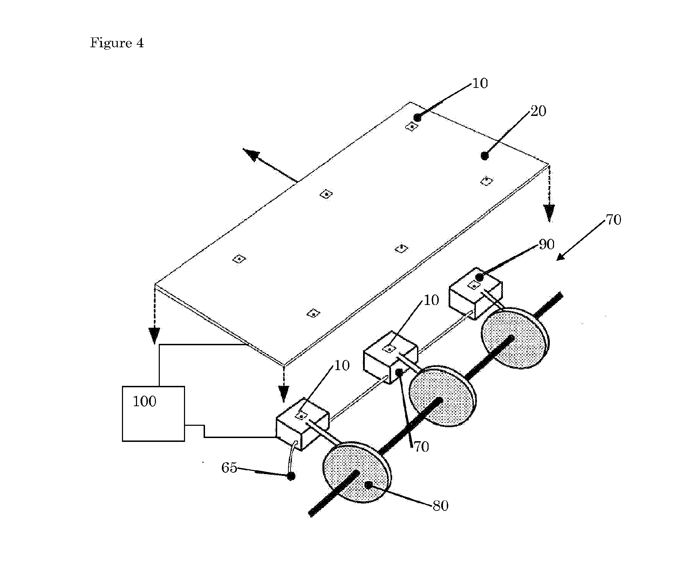

Figure 1 shows a direct pressure transfer through via openings 40 arranged in the flexible substrate 20. Alternatively, as can be seen in Figure 4, the alignment can be performed via a support structure of an intermediate support 70, where the components 10 are aligned using the same inventive principle of pressure assisted alignment via a structure arranged on a face of the substrate 20 or support 90 (see Fig 4).

In particular, a component placement method is disclosed for placement of a component 10 on a flexible substrate or foil 20. The method involves providing a flexible substrate 20; providing a component 10 to be placed on a predefined placement position 30; and providing directional structure 40 to direct the component 10 to the placement position 30.

In addition, a levitation force 50 is generated, oriented out of plane with respect to the foil 20, to induce the component 10 to move to the placement position 30. As will be illustrated further, the component 10 may be levitated from the placement position 30 by an air flow or by vibrational contact between the support face and the component induced by said air flow.

While the example shows the placement position in the form of a cavity 30, the provision of such is not necessary, and the structure 40 in the shown form or in other herein disclosed forms may already be sufficient for accurate placement.

In the example of Figure 1, the levitation force 50 is excited by a pressure chamber 60 arranged to levitate the component from the support face 20 by air flow 51. In this way, the pressure wave travels in a direction normal to the substrate 20 support and a substrate 20 arranged thereon. In this example, the directional structure is further formed by air vias 40 in the support face 21 arranged for passing of the air flow.

In the example, this directionality may be enhanced by varying the air vias 40 in size to provide a directional force. Specifically, the vias 40 may have a decreasing diameter towards the placement position 30. Alternatively, the density of air vias may be varied, to provide a gradiented air flow in effect. Alternatively to an acoustic source 60, an air supply or fan 65 may be present to provide a constant base flow.

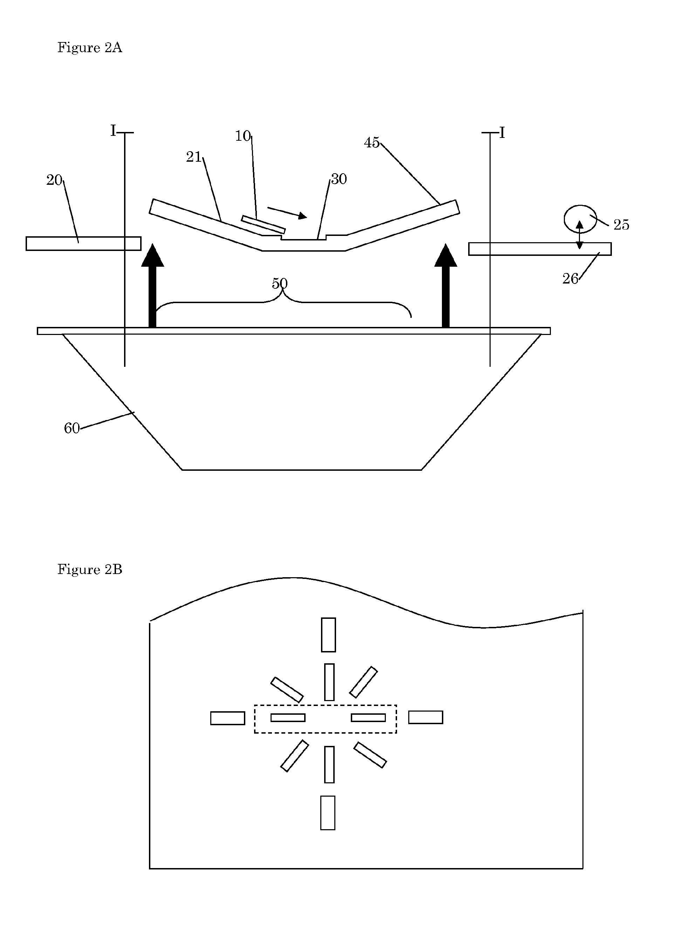

Figure 2 shows an alternative embodiment to Figure 1. Figure 2B shows a planar view of the region I-I, depicted in side view in Figure 2A. In this embodiment a pressure wave is transmitted via transfer to flaps or a microflap structure 45 that may be provided on a face 21 of the substrate 20. Alternatively, the flaps 45 may be part of a separate administering device 70 as shown in Figure 4. These substrate flaps 45 can be selectively excited to exhibit a resonance behavior and transfer the force to the component 10. The flaps 45 may be excited mechanically for example, via a piezo element 26 connection with the substrate 20, and/or via an acoustic device 60 generally designed as in Figure 1 providing an air flow that is pulsed in the region of typically below 1000 Hz. Thus additionally or alternatively, the directional structure may comprise a mechanical vibration element 26 arranged to transfer a vibration to the substrate 20.

In an example, the cantilever microflap structure 45 may be provided from PEN material (when for instance being part of the PEN foil substrate) having a typical thickness (t) of about100 micron thickness used for flexible substrates provided in flexible electronics. A cantilever length (L) may be varied in a range between 1 and 10 mm leading to frequencies between 1 and 1000 Hz. Preferably, the vibration frequency is thus selectively addressable so that the flaps or cantilever structures 45 can be used as actuation elements.

The following table provides a detailed example of cantilever length L, thickness t (100 mu), a mass density ρ (PEN) of 1,36 f/cm3 and a Young modulus E=3,6 GPa, where the frequency is related to the length by fo=(t/(4*Π*L^2))*(root(E/ρ)

| Length L(m) | Driving frequency fo in Hz |
|---|---|
| 1.00E-03 | 415 |
| 2.00E-03 | 103 |
| 3.00E-03 | 46 |
| 4.00E-03 | 25 |
| 5.00E-03 | 16 |
| 6.00E-03 | 11 |
| 7.00E-03 | 8 |
| 8.00E-03 | 6 |
| 9.00E-03 | 5 |
| 1.00E-02 | 4 |

In addition, by careful timing and placement of the vibrational element 26, a predefined vibrational pattern may be generated, wherein the component moves to a vibrational minimum zone.

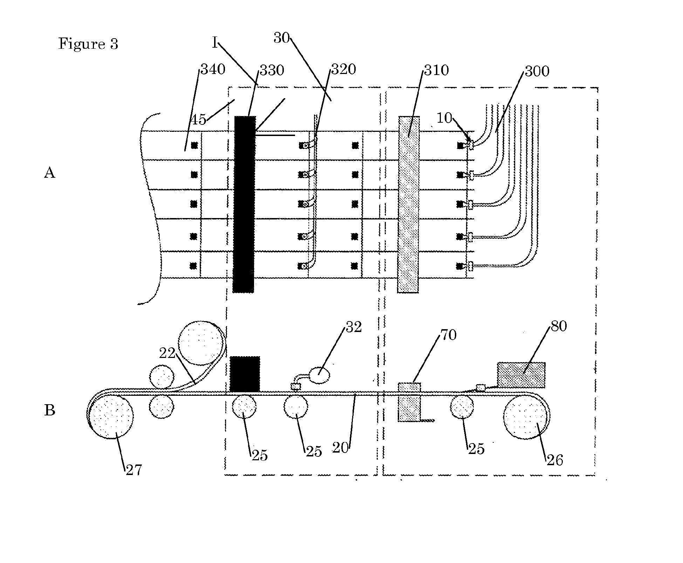

In Figure 3A it is schematically shown in plan view how these processes can be carried out on subsequent stations in the reel to reel process; Figure 3B shows the corresponding aspects in aspect view. In such a reel to reel method, a substrate 20 or carrier web is unwound from a first reel 26 and guided via a set of guide rollers 25 to a second reel 27 to be wound up. In the unwound condition, various sub processes can be carried out, in particular, as one of the sub processes, component placement 310 via a levitation force 50 as currently disclosed in the previous Figures. In particular, these sub processes may involve:
- supply 300 of a component 10, for example, a silicon based chip component 10, to the target area on the substrate 20;
- placement 310 of the chip component 10;
- fixation 320 of the chip 10 after its placement; and
- making 330 interconnects
- lamination 340 of the chips 10.

The steps may be integrated with one another, for example, fixation 310 and interconnects 320 may be provided in a single step by a suitable adhesive. After step 340, the chip assembly may be laminated in a protective substrate 22. Supply of components can be done by placement of chips on a carrier tape 80 and removing it there from in a conventional way, for example, by removal of the tape or by embossing. The chips may be released on a support face of the substrate 20 web directly, as disclosed in Figures 1 and 2, or to on a support face of an intermediate support 70 as disclosed in Figure 3. To position the components 10 after landing, in addition to the methods disclosed in Figures 1 and 2, further measures may be taken, including: air flow which attracts and temporarily holds the chip to the substrate 20, a droplet or adhesive 32 to fine position and temporarily hold the part on the basis of face tension forces to attract and temporarily hold the part. Another possibility is to use tapered air vias which lead to a rectification of air flow when modulated pressure is applied. Combining air vias with varying or opposing rectification properties could create even flows along the surface. Inducing translational movement of the component. In this way, through a sequence of "linked force fields" the chip 10 will go to its final position by an air flow or by vibrational contact between the support face and the component induced by said air flow, as described in the embodiments of Figures 1 and 2.

Figure 4 shows an embodiment of such intermediate support 70 as alternative embodiment. This intermediate support functions as an administering device 70 for administering of aligned components 10 to predetermined placement positions. The administering device 70 to this end comprises a component 10 inlet, a support zone 90, provided with the directional structure 40, and an alignment system 100 to align the support zone 90 with a predetermined substrate 20 position. An additional air supply may be provided to the administering device 70 to enhance levitation.

The administering device 70 may thus comprise a module which roughly positions a number of chips 10 in parallel on the substrate 20 on respective placement positions and an air flow coming from underneath the substrate 20 which would allow for many chips 10 to be aligned / assembled at the same time.

While the invention has been illustrated and described in detail in the drawings and foregoing description, such illustration and description are to be considered illustrative or exemplary and not restrictive; the invention is not limited to the disclosed embodiments. In particular, unless clear from context, aspects of various embodiments that are treated in various embodiments separately discussed are deemed disclosed in any combination variation of relevance and physically possible and the scope of the invention extends to such combinations. For example, functions of the inlet and administering device may be combined in one device or in separate devices. Furthermore, the pressure wave 50 may be provided by acoustic or mechanical vibration or a combination thereof. Other variations to the disclosed embodiments can be understood and by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

Various advantages of the disclosed method may include:
- no need for specific adaptations of the chip component 10 to promote the placement;
- the placement method is inexpensive due to absence of mechanical devices. Local openings in the substrate 20 and a broad area air-flow or acoustic excitation can be easily provided.
- Air flow or acoustic frequencies can be easily tuned;
- Chip can travel over large distances and will always see a net force in direction to the target position;
- Friction problems can be overcome by air cushion effect or intermittent contact facilitated by vibrating elements.

## Claims

1. A component (10) placement method for placement of a component (10) on a flexible substrate (20), comprising:
- providing a flexible substrate (20);
- administering a component (10) to a support face (21, 90), the support face comprised of by the flexible substrate or by a support structure (70) to be aligned with the flexible substrate (20);
- generating an air flow in an out of plane orientation relative to the support face(21, 90); and
- directing the component (10) to a placement position (30) by means of a directional structure (40, 45) provided on the support face (21, 90);
- wherein the component (10) is levitated from the support face (21, 90) by said air flow or by vibrational contact between the support face and the component (10) induced by said air flow; and wherein, when the support face (21, 90) is comprised by a support structure (70) distinct from the flexible substrate (20), the support face is aligned with the flexible substrate.

2. A method according to claim 1, wherein said air flow is pulsed in the region of 1-1000 Hz.

3. A method according to claim 1, wherein the directional structure comprises air vias (40) in the support face (21, 90) arranged for passing of the air flow.

4. A method according to claim 3, wherein the air vias (40) are varied in size and/or density to provide a directional force.

5. A method according to claim 1, wherein the directional structure comprises a microflap structure (45) arranged to levitate the component by vibrational contact.

6. A system for placement of a component (10) on a flexible substrate (20), comprising:
- a substrate support (25) for supporting a flexible substrate (20);
- a support face (21, 90) comprised of by the flexible substrate or by a support structure distinct from and to be aligned with the flexible substrate;
- an administering device (70) for administering a component (10) to the support face (21, 90);
- a pressure chamber (60) adjacent said support face (21, 90), arranged to generate an air flow in an out of plane orientation relative to the support face (21, 90); and
- a directional structure arranged on the support face (21, 90), arranged to direct the component (10) to a placement position (30);
- said pressure chamber (60) arranged to levitate the component (10) from the support face (21, 90) by said air flow or by vibrational contact between the support face (21, 90) and the component induced by said air flow; and, when the support face is comprised by a support structure distinct from the flexible substrate,
- an alignment system (100) for alignment of the support face with the flexible substrate.

7. A system according to claim 6, wherein the pressure chamber comprises an acoustic wave generator (60) arranged provided by a pulsed pressure in the region of 4-400 Hz.

8. A system according to claim 6, wherein the directional structure comprises air vias (40) in the support face arranged for passing of the air flow.

9. A system according to claim 8, wherein the vias (40) vary in size and/or density to provide a directional force.

10. A system according to claim 6, wherein the directional structure comprises a microflap structure (45) arranged to levitate the component by vibrational contact.

11. A system according to claim 6, wherein the support face (90) is provided on the administering device (70).
